(19) Europäisches Patentamt
European Patent Office
Office européen des brevets

(11) EP 1 158 843 B1

(12) EUROPEAN PATENT SPECIFICATION

(45) Date of publication and mention of the grant of the patent:
**13.09.2006 Bulletin 2006/37**

(51) Int Cl.:
***H05K 3/38*** *(2006.01)* ***C23F 1/18*** *(2006.01)*
***C23C 22/52*** *(2006.01)*

(21) Application number: **00304292.6**

(22) Date of filing: **22.05.2000**

(54) **Process for improving adhesion of polymeric materials to metal surfaces.**
Verfahren zur Verbesserung der Adhäsion von Polymermaterialien an Metalloberflächen
Procédé d'amélioration de l'adhésion de matériaux polymères aux surfaces métalliques

(84) Designated Contracting States:
**BE DE ES FR GB IT**

(43) Date of publication of application:
**28.11.2001 Bulletin 2001/48**

(73) Proprietor: **MACDERMID INCORPORATED**
**Waterbury,**
**Connecticut 06702 (US)**

(72) Inventor: **Ferrier, Donald**
**Thomaston, CT 06787 (US)**

(74) Representative: **Jenkins, Peter David et al**
**PAGE WHITE & FARRER**
**54 Doughty Street**
**London WC1N 2LS (GB)**

(56) References cited:
**EP-A- 0 887 439**
**EP-A- 1 020 503**
**US-A- 4 619 871**
**US-A- 5 376 387**
**US-A- 5 550 006**
**US-A- 5 800 859**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

The present invention relates to printed circuits, and more particularly to a process for fabricating a multilayer printed circuit.

Printed circuits containing one or more circuitry innerlayers are in prominent use today as demand increases for further and further weight and space conservation in electronic devices.

In the typical fabrication of a multilayer printed circuit, patterned circuitry innerlayers are first prepared by a process in which a copper foil-clad dielectric substrate material is patterned with resist in the positive image of the desired circuitry pattern, followed by etching away of the exposed copper. Upon removal of the resist, there remains the desired copper circuitry pattern.

One or more circuitry innerlayers of any particular type or types of circuitry pattern, as well as circuitry innerlayers which might constitute ground planes and power planes, are assembled into a multilayer circuit by interposing one or more partially-cured dielectric substrate material layers (so-called "pre-preg" layers) between the circuitry innerlayers to form a composite of alternating circuitry innerlayers and dielectric substrate material. The composite is then subjected to heat and pressure to cure the partially-cured substrate material and achieve bonding of circuitry innerlayers thereto. The so-cured composite will then have a number of through-holes drilled therethrough, which are then metallized to provide a means for conductively interconnecting all circuitry layers. In the course of the through-hole metallizing process, desired circuitry patterns also typically will be formed on the outer-facing layers of the multilayer composite.

An alternate approach to the formation of a multilayer printed circuit board is through additive or surface laminer circuitry techniques. These techniques begin with a non-conductive substrate, upon which the circuit elements are additively plated. Further layers are achieved by repeatedly applying an imageable coating upon the circuitry and plating further circuit elements upon the imageable coating.

It has long been known that the strength of the adhesive bond formed between the copper metal of the circuitry innerlayers and the cured pre-preg layers, or other non-conductive coatings, in contact therewith leaves something to be desired, with the result that the cured multilayer composite or the coating is susceptible to delamination in subsequent processing and/or use. In response to this problem, the art developed the technique of forming on the copper surfaces of the circuitry innerlayers (before assembling them with pre-preg layers into a multilayer composite) a layer of copper oxide, such as by chemical oxidation of the copper surfaces. The earliest efforts in this regard (so-called "black oxide" adhesion promoters) produced somewhat minimal improvement in the bonding of the circuitry innerlayers to the dielectric substrate layers in the final multilayer circuit, as compared to that obtained without copper oxide provision. Subsequent variations on the black oxide technique included methods wherein there is first produced a black oxide coating on the copper surface, followed by post-treatment of the black oxide deposit with 15% sulfuric acid to produce a "red oxide" to serve as the adhesion promoter, such as disclosed by A. G. Osborne, "An Alternate Route To Red Oxide For Inner Layers", PC Fab. August, 1984, as well as variations involving direct formation of red oxide adhesion promoter, with varying degrees of success being obtained. The most notable improvement in this art is represented in the U.S. Pat. Nos. 4,409,037 and 4,844,981 to Landau, involving oxides formed from relatively high chlorite/relatively low caustic copper oxidizing compositions, and producing substantially improved results in circuitry innerlayer adhesion.

As earlier noted, the assembled and cured multilayer circuit composite is provided with through-holes which then require metallization in order to serve as a means for conductive interconnection of the circuitry layers of the circuit. The metallizing of the through-holes involves steps of resin desmearing of the hole surfaces, catalytic activation, electroless copper depositing, electrolytic copper depositing, and the like. Many of these process steps involve the use of media, such as acids, which are capable of dissolving the copper oxide adhesion promoter coating on the circuitry innerlayer portions exposed at or near the through hole. This localized dissolution of the copper oxide, which is evidenced by formation around the through-hole of a pink ring or halo (owing to the pink color of the underlying copper metal thereby exposed), can in turn lead to localized delamination in the multilayer circuit.

The art is well aware of this "pink ring" phenomenon, and has expended extensive effort in seeking to arrive at a multilayer printed circuit fabrication process which is not susceptible to such localized delamination. One suggested approach has been to provide the adhesion promoting copper oxide as a thick coating so as to retard its dissolution in subsequent processing simply by virtue of sheer volume of copper oxide present. This turns out to be essentially counter-productive, however, because the thicker oxide coating is inherently less effective as an adhesion promoter per se. Other suggestions relating to optimization of the pressing/curing conditions for assembling the multilayer composite have met with only limited success.

Other approaches to this problem involve post-treatment of the copper oxide adhesion promoter coating prior to assembly of circuitry innerlayers and pre-preg layers into a multilayer composite. For example, U.S. Pat. No. 4,775,444 to Cordani discloses a process in which the copper surfaces of the circuitry innerlayers are first provided with a copper oxide coating and then contacted with an aqueous chromic acid solution before the circuitry innerlayers are incorporated into the multilayer assembly. The treatment serves to stabilize and/or protect the copper oxide coating from dissolution in the acidic media encountered in subsequent processing steps (e.g. through-hole metallization), thereby minimizing

pink ring/delamination possibilities.

U.S. Pat. No. 4,642,161 to Akahoshi et al, U.S. Pat. No. 4,902,551 to Nakaso et al, and U.S. Pat. No. 4,981,560 to Kajihara et al, and a number of references cited therein, relate to processes in which the copper surfaces of the circuitry innerlayers, prior to incorporation of the circuitry innerlayers into a multilayer circuit assembly, are first treated to provide a surface coating of adhesion-promoting copper oxide. The copper oxide so formed is then reduced to metallic copper using particular reducing agents and conditions. As a consequence, the multilayer assembly employing such circuitry innerlayers will not evidence pink ring formation since there is no copper oxide present for localized dissolution, and localized exposure of underlying copper, in subsequent through-hole processing. As with other techniques, however, processes of this type are suspect in terms of the adhesion attainable between the dielectric substrate layers and the metallic copper circuitry innerlayers. This is particularly so in these reduction processes since the circuitry bonding surface not only is metallic copper, but also presents the metallic copper in distinct phases (i.e., (1) copper-from-reduction-of-copper oxide over (2) copper of the copper foil) which are prone to separation/delamination along the phase boundary.

U.S. Pat Nos. 4,997,722 and 4,997,516 to Adler similarly involve formation of a copper oxide coating on the copper surfaces of circuitry innerlayers, followed by treatment with a specialized reducing solution to reduce the copper oxide to metallic copper. Certain portions of the copper oxide apparently may not be reduced all the way to metallic copper (being reduced instead to hydrous cuprous oxide or cuprous hydroxide), and those species are thereafter dissolved away in a non-oxidizing acid which does not attack or dissolve the portions already reduced to metallic copper. As such, the multi-layer assembly employing such circuitry innerlayers will not evidence pink ring formation since there is no copper oxide present for localized dissolution, and localized exposure of underlying copper, in subsequent through-hole processing. Here again, however, problems can arise in terms of the adhesion between the dielectric layers and metallic copper circuitry innerlayers, firstly because the bonding surface is metallic copper, and secondly because the metallic copper predominately is present in distinct phases (i.e., (1) copper-from-reduction-of-copper oxide over (2) copper of the copper foil), a situation prone to separation/delamination along the phase boundary.

U.S. Patent No. 5,289,630 to Ferrier et al., reveals a process whereby an adhesion promoting layer of copper oxide is formed on the circuit elements followed by a controlled dissolution and removal of a substantial amount of the copper oxide in a manner which does not adversely affect the topography.

PCT Application No. WO 96/19097 to McGrath (and related U.S. Patent No. 5,800,859), discusses a process for improving the adhesion of polymeric materials to a metal surface. The process discussed involves contacting the metal surface with an adhesion-promoting composition comprising hydrogen peroxide, an inorganic acid, a corrosion-inhibitor and a quaternary ammonium surfactant.

US 5 376 387 describes a composition for cleaning metal surfaces including a benzotriazole with a $-CH_2N(CH_2CH_2OH)_2$ group in the 1-position.

This invention proposes a process for improving the adhesion of polymeric materials to a metal surface, especially copper or copper alloy surfaces. The process proposed herein is particularly useful in the production of multilayer printed circuits. The process proposed herein provides optimum adhesion between the metallic and polymeric surfaces (ie. the circuitry and the intermediate insulating layer), eliminates or minimizes pink ring and operates economically, all as compared to conventional processes.

The present invention provides a composition for treating metal surfaces prior to bonding polymeric materials thereto according to claim 1 or claim 5. The present invention also provides a method for adhering a polymeric material to a metal surface according to claim 10 or claim 12.

The inventors have found that the process of the present invention improves the adhesion of metal surfaces to the polymeric materials, particularly when the metal surfaces comprise copper or copper alloys. The process proposed is particularly suited to the production of multilayer printed circuit boards.

The composition of the present invention may optionally include a water soluble polymer.

The inventors have found that the adhesion-promoting composition of the present invention produces a micro-roughened conversion-coated surface upon the metal. The surface produced is particularly suited to bonding with polymeric materials in that significantly increased adhesion values are achieved as compared to a non-treated metal surface. In addition the conversion coated (treated) metal surface maintains the increased adhesion over time and decreases the likelihood of any unwanted reactions occurring over time between the metal and the polymeric material.

The process proposed is particularly suited to the manufacture of multilayer printed circuit boards. Thus, in this application, the metal circuitry (usually copper) of the innerlayers is treated with the adhesion-promoting composition proposed herein. After treatment, followed by water rinsing, the innerlayers are bonded together with polymeric materials such as pre-pregs or imageable dielectrics, resulting in the multilayer printed circuit board.

The metal surface to be treated may comprise a variety of metals such as copper, copper alloys, nickel and iron. However, the process of the invention produces the best results when the metal surfaces comprise copper or copper alloys. The polymeric material may be a variety of polymeric materials including pre-preg materials, imageable dielectrics, photoimageable resins, soldermasks, adhesives or polymeric etch resists.

The oxidizer used in the adhesion-promoting composition may comprise any oxidizer which is capable of

oxidizing the metal surface in the matrix of the adhesion-promoting composition. The inventors have found hydrogen peroxide and persulfates to be particularly preferred oxidizers for use in the process of the invention, with hydrogen peroxide being the most preferred oxidizer. The concentration of the oxidizer in the adhesion-promoting composition may range from 2 to 60 grams per liter but is preferably from 3 to 30 grams per liter.

The acid utilized in the adhesion-promoting composition may be any acid which is stable in the matrix, however, the inventors have found mineral acids to be particularly preferred. Sulfuric acid is especially preferred. The concentration of the acid in the adhesion-promoting composition may range from 5 to 360 grams per liter but is preferably from 20 to 110 grams per liter.

The corrosion inhibitor used in the adhesion-promoting composition is a compound which effectively reacts with the metal surface to form a protective complex layer. Preferred corrosion inhibitors are selected from the group consisting of triazoles, benzotriazoles, tetrazoles, imidazoles, benzimidazoles and mixtures of the foregoing. Benzotriazoles are particularly preferred. The concentration of the corrosion inhibitor in the adhesion-promoting composition may range from 0.2 to 20 grams per liter but is preferably from 1 to 12 grams per liter.

The inventors have found that the addition of a benzotriazole with an electron withdrawing group in the 1-position, which electron withdrawing group is a stronger electron withdrawer than a hydrogen group, produces advantages with respect to the uniformity of the coating produced and the adhesion achieved after bonding. The inventors have found that the electron withdrawing group is preferably selected from the group consisting of hydroxy groups, amino groups, nitro groups, nitrile groups, sulfonate groups, carboxylate groups, halide groups, mercaptan groups and unsaturated alkyl groups. Most preferably the electron withdrawing group is a hydroxy group and thus the most preferable material in this regard is 1-hydroxy benzotriazole with the following structure:

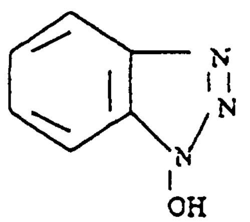

The corrosion inhibitor and the benzotriazole with an electron withdrawing group in the 1-position may both be the same compound. For instance, 1-hydroxybenzotriazole may fill the roles of both the corrosion inhibitor and the benzotriazole with the electron withdrawing group in the 1-position.

The advantages achievable with the use of the foregoing materials are most pronounced when a source of adhesion enhancing species, as described below, is used in conjunction with the foregoing materials in the adhesion-promoting composition. The inventors have found that the combination proposed produces synergistic effects. The concentration of the benzotriazole with the electron withdrawing group in the 1-position can range from 0.2 g/l to 20 g/l but is preferably from 0.5 g/l to 5 g/l.

The source of adhesion enhancing species can be any material which will supply species selected from the group consisting of molybdates, tungstates, tantalates, niobates, vanadates and mixtures thereof to the adhesion promoting composition. Such sources include alkali metal salts of molybdates, tungstate, tantalates, niobates, vanadates and mixtures thereof such as sodium (or potassium) molybdate, tungstate, niobate or vanadate, and heteropoly acids or isopoly acids of molybdenum, tungsten, tantalum, niobium or vanadium. Thus, molybdates or tungstates which include hetero atoms such as phosphorous, silicon, cobalt, manganese and tungsten are suitable. Preferred sources include iso and hetero polyacids of molybdenum, tungsten, niobium, vanadium and mixtures thereof such as molybdic acid, vanadic acid and tungstic acid. The most preferred source of adhesion enhancing species is molybdic acid. The concentration of adhesion enhancing species in the adhesion promoting composition may range from 1 mg/l to 500 mg/l (based on the adhesion enhancing ion content) but is preferably from 5 mg/l to 200 mg/l.

Optionally, the adhesion-promoting composition may also comprise a water soluble polymer. If used, the water soluble polymer is preferably not a wetter or surfactant but is instead a water soluble homopolymer or copolymer of low molecular weight water soluble monomers. Most preferably, the water soluble polymer is a polymer of ethylene oxide, an ethylene oxide-propylene oxide copolymer, polyethylene glycols, polypropylene glycols or polyvinyl alcohols. Among the most preferred are the polymers of ethylene oxide, or polyethylene glycols sold by the Union Carbide company under the tradename Carbowax. The inventors have found Carbowax 750 and Carbowax MPEG 2000 to be particularly useful. Also particularly useful are the ethylene oxide polymers or ethylene oxide-propylene oxide copolymers sold by the BASF company under the Pluronic tradename. The concentration of the water soluble polymer in the adhesion-promoting

composition can range from 1 to 15 grams per liter, but is preferably from 3 to 6 grams per liter.

The metal surface can be treated with the adhesion-promoting composition in a variety of ways, including immersion, spray, or flood. The temperature of the adhesion-promoting composition during treatment may range from 26.7˚C (80˚F) to 66˚C (150˚F) but is preferably from 32.2˚C (90˚F) to 49˚C (120˚F). The treatment time will vary depending upon the temperature and method of treatment but may range from 15 seconds to 15 minutes and is preferably from 1 to 2 minutes.

The following Examples 2 to 15 are illustrative of the invention but should not be taken as limiting. Reference Example 1 is not in accordance with the claimed invention.

The following cycle was used in processing the copper clad panels and copper foils in all of the following examples:

| | Time (Min) |
|---|---|
| 5% Sulfuric acid, 21.1˚C (70˚F) | |
| Cold Water Rinse | 1 |
| Metex Brass Soak Cleaner S-426, 66˚C (150˚F) | 2 |
| Cold Water Rinse | 2 |
| Predip (2 gr/l benzotriazole, 1% v/v 50% $H_2O_2$), 21.1˚C (70˚F) | 1 |
| Test Solution | 1 |
| Cold Water Rinse | 1 |
| Forced Air Dry | 1 |

Reference Example 1 and Examples 2 to 15.

A base adhesion-promoting solution was prepared containing 2% by volume sulfuric acid (98% by weight), 0.75% by volume of 50% by weight hydrogen peroxide, 4 gr/l benzotriazole and the remainder water. For each example the amount of hydroxybenzotriazole hydrate and molybdic acid shown in Table I below were added to the foregoing base solution and copper foils and panels were processed through the standard cycle noted above with the specified test solution in each case at the temperatures indicated for each example. The appearance achieved for each example is noted in Table I below.

Table I

| Example | 1-Hydroxybenzotriazole hydrate | Molybdic Acid | Temperature (100˚F = 37.8˚C, 110˚F = 43˚C, 120˚F = 49˚C) | Appearance |
|---|---|---|---|---|
| 1 | 0 g/L | 0 mg/L | 100˚F | nonuniform dark pink |
| 2 | 1 g/L | 0 mg/L | 100˚F | nonuniform dark pink |
| 3 | 2 g/L | 0- mg/L | 100˚F | uniform dark pink |
| 4 | 3 g/L | 0 mg/L | 100˚F | uniform dark pink |
| 5 | 3 g/L | 0 mg/L | 110˚F | uniform very dark pink |
| 6 | 3 g/L | 0 mg/L | 120˚F | uniform dark pink |
| 7 | 3 g/L | 10 mg/L | 100˚F | nonuniform dark brown |
| 8 | 3 g/L | 10 mg/L | 110˚F | uniform very dark brown |
| 9 | 3 g/L | 10 mg/L | 120˚F | uniform dark brown |
| 10 | 3 g/L | 20 mg/L | 100˚F | uniform very dark brown |
| 11 | 3 g/L | 20 mg/L | 110˚F | uniform dark brown |
| 12 | 3 g/L | 20 mg/L | 120˚F | uniform dark brown |
| 13 | 3 g/L | 30 mg/L | 100˚F | uniform brown |
| 14 | 3 g/L | 30 mg/L | 110˚F | uniform dark brown |
| 15 | 3 g/L | 30 mg/L | 120˚F | uniform very dark brown |

After processing the panels and foils were baked for 30 minutes at 110˚C (230˚F), then laminated at 177˚C (350˚F) and 200 pounds per square inch pressure (1 p.s.i. = 0.069 bar) for 45 minutes with NELCO N4205-2 B Stage (FR-4) (available from the NELCO Company). The B-Stage consisted of one sheet of 7628 glass sandwiched between two sheets of 1080 glass. Following lamination the panels were imaged to form one inch wide strips and excess copper was removed. The stripped panels were baked for 2 hours at 110˚C (230˚F), then immersed in 288˚C (550˚F) solder for zero, ten and twenty seconds. The strength of the copper to resin bond was measured by peeling the foil strips from the resin and the results are reported in Table II below.

Table II

| (1 lb/in = 0.45 Kg / 25.4 mm) | | | | | |
|---|---|---|---|---|---|
| Example | Appearance | Appearance after Solder | Peel Strength, 0 Seconds Solder | Peel Strength, 10 Seconds Solder | Peel Strength, 20 Seconds Solder |
| 1 | nonuniform dark pink | nonuniform dark pink | 3.5 lb/in | 3.2 lb/in | 3.8 lb/in |
| 2 | nonuniform very dark pink | nonuniform very dark pink | 4.2 lb/in | 3.8 lb/in | 3.8 lb/in |
| 3 | uniform brown/ pink | uniform brown/ pink | 4.8 1b/in | 4/5 lb/in | 4.2 lb/in |
| 4 | uniform brown/ pink | uniform brown/ pink | 5.5 lb/in | 5.0 lb/in | 5.0 lb/in |
| 5 | uniform dark brown | uniform dark brown | 6.0 lb/in | 4.8 lb/in | 4.8 lb/in |
| 6 | uniform dark brown | uniform dark brown | 3.0 lb/in | 2.0 lb/in | 1.8 lb/in |
| 7 | uniform dark brown | uniform dark brown | 5.2 lb/in | 4.8 lb/in | 4.8 lb/in |
| 8 | uniform purple/ brown | uniform purple/ brown | 62 lb/in | 5.5 lb/in | 5/2 lb/in |
| 9 | uniform purple/ brown | uniform purple/ brown | 6.2 1b/in | 5.8 1b/in | 5.0 lb/in |
| 10 | uniform purple/ brown | uniform purple/ brown | 5.5 lb/in | 5.0 1b/in | 4.8 lb/in |
| 11 | uniform purple/ brown | uniform purple/ brown | 5.8 1b/in | 5.2 1b/in | 5.2 lb/in |
| 12 | uniform purple/ brown | uniform purple/ brown | 6.0 1b/in | 5.2 1b/in | 4.8 lb/in |
| 13 | uniform purple/ brown | uniform purple/ brown | 5.5 1b/in | 5.0 1b/in | 4.8 lb/ia |
| 14 | uniform purple/ brown | uniform purple/ brown | 5.5 lb/in | 5.0 lb/in | 5.0 lb/in |
| 15 | uniform purple/ brown | uniform purple/ brown | 5.5 lb/in | 5.0 lb/in | 4.2 lb/in |

The examples clearly demonstrate the advantages achievable in appearance and adhesion with the process of this invention.

Comparative Example

Reference Example 1 was repeated except that in this case the concentration of benzotriazole in the test solution was increased from 4 gr/l to 7 gr/l. As in Reference Example 1, no 1-hydroxybenzotriazole or molybdic acid was used. The result was a uniform pink appearance. The peel strength achieved was 2.8 $^{lb}$/in, 2.5 $^{lb}$/in and 2.5 $^{lb}$/in (1 lb/in = 0.45 kg/25.4 mm) for 0 sec., 10 sec. and 20 sec. respectively in 288˚C (550˚F) solder.

## Claims

1. A composition useful for treating metal surfaces prior to bonding polymeric materials to the metal surfaces, said composition comprising:

    a. an oxidizer;
    b. an acid;
    c. a corrosion inhibitor,
    d. a benzotriazole with an electron withdrawing group in the 1-position which electron withdrawing group is a stronger electron withdrawer than a hydrogen group; and
    e. a source of adhesion enhancing species, which species are selected from the group consisting of molybdates, tungstates, tantalates, niobates, vanadates, isopoly or heteropoly acids of molybdenum, tungsten, tantalum, niobium, vanadium, and combinations of any of the foregoing.

2. A composition according to claim 1 wherein the oxidizer is selected from the group consisting of hydrogen peroxide and persulfates.

3. A composition according to claim 1 wherein the electron withdrawing group is selected from the group consisting of hydroxy groups, amino groups, nitro groups, nitrile groups, sulfonate groups, carboxylate groups, halide groups, mercaptan groups, and unsaturated alkyl groups.

4. A composition according to claim 3 wherein the benzotriazole with the electron withdrawing group is 1-hydroxy benzotriazole with the following structure:

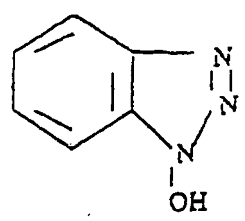

5. A composition for treating metal surfaces prior to bonding polymeric materials to the metal surfaces, said composition comprising:

    a. an oxidizer;
    b. an acid;
    c. 1-hydroxybenzotriazole; and
    d. optionally, a source of adhesion enhancing species, which species are selected from the group consisting of molybdates, tungstates, tantalates, niobates, vanadates, isopoly or heteropoly acids of molybdenum, tungsten, tantalum, niobium, vanadium and combinations of the foregoing.

6. A composition according to claim 5 wherein the composition also comprises a corrosion inhibitor other than 1-hydroxybeazotriazole.

7. A composition according to any preceding claim wherein the adhesion enhancing species are present and comprise molybdate ions.

**8.** A composition according to any preceding claim wherein the acid is a mineral acid and the oxidizer is selected from the group consisting of hydrogen peroxide and persulfates.

**9.** A composition according to claim 1 or claim 6 wherein the corrosion inhibitor is selected from the group consisting of triazoles, benzotriazoles, imidazoles, benzimidazoles, tetrazoles and combinations of any of the foregoing.

**10.** A process for adhering a polymeric material to a metal surface, said process comprising:

a. contacting the metal surface with an adhesion promoting composition according to any of claims 1 to 9; and
b. bonding the polymeric material to the metal surface.

**11.** A process according to claim 10 wherein the metal surface comprises copper.

**12.** A process for adhering a polymeric material to a metal surface, said process comprising: (a) contacting the metal surface with a composition comprising an oxidiser, an acid, a corrosion inhibitor and a benzotriazole with an electron withdrawing group in the 1-position which electron withdrawing group is a stronger electron withdrawer than a hydrogen group; and (b) then bonding a polymeric material to the metal surface

**13.** A process according to claim 12, wherein the oxidiser comprises hydrogen peroxide.

**14.** A process according to claim 12 or claim 13, wherein the electron withdrawing group is selected from the group consisting of hydroxyl group, amino groups, nitro groups, nitrite groups, sulfonate groups, carboxylate groups, halide groups, mercaptan groups and unsaturated alkyl groups.

**15.** A process according to claim 12 or claim 13, wherein the benzotriazole with an electron withdrawing group in the 1-position is 1-hydroxy benzotriazole.

## Patentansprüche

**1.** Zusammensetzung, die zur Behandlung von Metalloberflächen vor dem Verbinden von Polymermaterialen mit den Metalloberflächen nützlich ist, wobei die Zusammensetzung umfasst:

a. ein Oxidationsmittel;
b. eine Säure;
c. einen Korrosionsinhibitor;
d. ein Benzotriazol mit einer elektronenabziehenden Gruppe in der Position 1, wobei die elektronenabziehende Gruppe eine stärker elektronenabziehende Gruppe als eine Wasserstoffgruppe ist; und
e. eine Quelle von die Haftung verbessernden Spezies, wobei die Spezies ausgewählt sind aus der Gruppe bestehend aus Molybdaten, Wolframaten, Tantalaten, Niobaten, Vanadaten, Isopoly- oder Heteropolysäuren von Molybdän, Wolfram, Tantal, Niob, Vanadium und Kombinationen von irgendwelchen der vorangehenden.

**2.** Zusammensetzung nach Anspruch 1, in der das Oxidationsmittel ausgewählt ist der Gruppe bestehend aus Wasserstoffperoxid und Persulfaten.

**3.** Zusammensetzung nach Anspruch 1, in der die elektronenabziehende Gruppe ausgewählt ist aus der Gruppe bestehend aus Hydroxygruppen, Aminogruppen, Nitrogruppen, Nitrilgruppen, Sulfonatgruppen, Carboxylatgruppen, Halogenidgruppen, Mercaptangruppen und ungesättigten Alkylgruppen.

**4.** Zusammensetzung nach Anspruch 3, in der das Benzotriazol mit der elektronenabziehenden Gruppe 1-Hydroxybenzotriazol mit der folgenden Struktur ist:

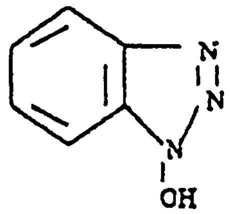

**5.** Zusammensetzung zur Behandlung von Metalloberflächen vor dem Verbinden von Polymermaterialien mit den Metalloberflächen, wobei die Zusammensetzung umfasst:

a. ein Oxidationsmittel;
b. eine Säure;
c. 1-Hydroxybenzotriazol; und
d. gegebenenfalls eine Quelle von die Haftung verbessernden Spezies, wobei die Spezies ausgewählt sind aus der Gruppe bestehend aus Molybdaten, Wolframaten, Tantalaten, Niobaten, Vanadaten, Isopoly- oder Heteropolysäuren von Molybdän, Wolfram, Tantal, Niob, Vanadium und Kombinationen der vorangehenden.

**6.** Zusammensetzung nach Anspruch 5, in der die Zusammensetzung auch einen Korrosionsinhibitor umfasst, der von 1-Hydroxybenzotriazol verschieden ist.

**7.** Zusammensetzung nach irgendeinem vorangehenden Anspruch, in der die die Haftung verbessernden Spezies vorliegen und Molybdationen umfassen.

**8.** Zusammensetzung nach irgendeinem vorangehenden Anspruch, in der die Säure eine Mineralsäure ist und das Oxidationsmittel ausgewählt ist aus der Gruppe bestehend aus Wasserstoffperoxid und Persulfaten.

**9.** Zusammensetzung nach Anspruch 1 oder Anspruch 6, in der der Korrosionsinhibitor ausgewählt ist aus der Gruppe bestehend aus Triazolen, Benzotriazolen, Imidazolen, Benzimidazolen, Tetrazolen und Kombinationen von irgendwelchen der vorangehenden.

**10.** Verfahren zum Kleben eines Polymermaterials an eine Metalloberfläche, wobei das Verfahren umfasst:

a. In-Kontakt-Bringen der Metalloberfläche mit einer haftungsfördernden Zusammensetzung gemäß irgendeinem der Ansprüche 1-9.
b. Verbinden des polymeren Materials mit der Metalloberfläche.

**11.** Verfahren nach Anspruch 10, in dem die Metalloberfläche Kupfer umfasst.

**12.** Verfahren zum Kleben eines polymeren Materials an eine Metalloberfläche, wobei das Verfahren umfasst: (a) In-Kontakt-Bringen der Metalloberfläche mit einer Zusammensetzung, die eine Oxidationsmittel, eine Säure, einen Korrosionsinhibitor und ein Benzotriazol mit einer elektronenabziehenden Gruppe in der Position 1 umfasst, wobei die elektronenabziehende Gruppe eine stärker elektronenabziehende Gruppe als eine Wasserstoffgruppe ist; und (b) anschließendes Verbinden eines polymeren Materials mit der Metalloberfläche.

**13.** Verfahren nach Anspruch 12, in dem das Oxidationsmittel Wasserstoffperoxid umfasst.

**14.** Verfahren nach Anspruch 12 oder Anspruch 13, in dem die elektronenabziehende Gruppe ausgewählt ist aus der Gruppe bestehend aus der Hydroxylgruppe, Aminogruppen, Nitrogruppen, Nitritgruppen, Sulfonatgruppen, Carboxylatgruppen, Halogenidgruppen, Mercaptangruppen und ungesättigten Alkylgruppen.

**15.** Verfahren nach Anspruch 12 oder Anspruch 13, in dem das Benzotriazol mit einer elektronenabziehenden Gruppe in der Position 1 1-Hydroxybenzotriazol ist.

**Revendications**

1. Composition utile au traitement de surfaces métalliques avant une liaison avec des matériaux polymères sur les surfaces métalliques, cette composition comprenant :

   a. un oxydant ;
   b. un acide ;
   c. un inhibiteur de corrosion ;
   d. un benzotriazole ayant un groupe d'enlèvement d'électrons en position 1, ce groupe d'enlèvement d'électrons étant un élément d'enlèvement d'électrons plus fort qu'un groupe hydrogène ; et
   e. une source d'espèces augmentant l'adhérence, ces espèces étant choisies dans le groupe comprenant des molybdates, des tungstates, des tantalates, des niobates, des vanadates, des isopoly- ou hétéropoly-acides de molybdène, tungstène, tantale, niobium, vanadium, et des combinaisons de ces éléments.

2. Composition selon la revendication 1, dans laquelle l'oxydant est choisi dans le groupe comprenant le peroxyde d'hydrogène et les persulfates.

3. Composition selon la revendication 1, dans laquelle le groupe d'enlèvement d'électrons est choisi dans le groupe comprenant le groupe hydroxyle, le groupe amino, le groupe nitro, le groupe nitrile, le groupe sulfonate, le groupe carboxylate, les groupes halogénures, le groupe mercaptan, et les groupes alkyles insaturés.

4. Composition selon la revendication 3, dans laquelle le benzotriazole comportant le groupe d'enlèvement d'électrons est le 1-hydroxybenzatriazole ayant la structure suivante :

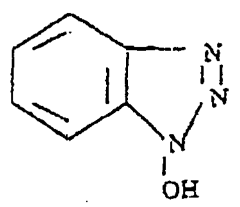

5. Composition pour traiter des surfaces métalliques avant de fixer des matériaux polymères sur les surfaces métalliques, cette composition comprenant :

   a. un oxydant ;
   b. un acide ;
   c. le 1-hydroxybenzotriazole ; et
   d. optionnellement, une source d'espèces augmentant l'adhérence, ces espèces étant choisies dans le groupe comprenant des molybdates, des tungstates, des tantalates, des niobates, des vanadates, des isopoly- ou hétéropoly-acides de molybdène, tungstène, tantale, niobium, vanadium, et des combinaisons de ces éléments.

6. Composition selon la revendication 5, comprenant également un inhibiteur de corrosion autre que 1-hydroxybenzotriazole.

7. Composition selon l'une quelconque des revendications précédentes, dans laquelle l'espèce augmentant l'adhérence est présente et comprend des ions molybdates.

8. Composition selon l'une quelconque des revendications précédentes, dans laquelle l'acide est un acide minéral et l'oxydant est choisi dans le groupe comprenant des peroxydes d'hydrogène et des persulfates.

9. Composition selon la revendication 1 ou 6, dans laquelle l'inhibiteur de corrosion est choisi dans le groupe comprenant les triazoles, benzotriazoles, imidazoles, benzimidazoles, tétrazoles et des combinaisons de ces éléments.

10. Procédé d'adhérence d'un matériau polymère sur une surface métallique, ce procédé comprenant :

    a. mettre la surface métallique en contact avec une composition favorisant l'adhérence selon l'une quelconque

des revendications 1 à 9 ; et
b. fixer le matériau sur la surface métallique.

**11.** Procédé selon la revendication 10, dans lequel la surface métallique comprend du cuivre.

**12.** Procédé pour augmenter l'adhérence d'un matériau polymère sur une surface métallique, ce procédé comprenant :

(a) contacter la surface métallique par une composition comprenant un oxydant, un acide, un inhibiteur de corrosion et un benzotriazole ayant un groupe d'enlèvement d'électrons en position 1, le groupe d'enlèvement d'électrons étant un élément d'enlèvement d'électrons plus fort qu'un groupe hydrogène ; et
(b) fixer ensuite un matériau polymère sur la surface métallique.

**13.** Procédé selon la revendication 12, dans lequel l'oxydant comprend un péroxyde d'hydrogène.

**14.** Procédé selon la revendication 12 ou 13, dans lequel le groupe d'enlèvement d'électrons est choisi dans le groupe comprenant le groupe hydroxyle, le groupe amino, le groupe nitro, le groupe nitrile, le groupe sulfonate, le groupe carboxylate, les groupes halogénures, le groupe mercaptan, et les groupes alkyles insaturés.

**15.** Procédé selon la revendication 12 ou 13, dans lequel le benzotriazole ayant un groupe d'enlèvement d'électrons en position 1 est le 1-hydroxybenzotriazole.